# EUROPEAN PATENT SPECIFICATION

(11) **EP 0 371 625 B1**
(45) Date of publication and mention of the grant of the patent: **24.01.1996**
(21) Application number: 89311325.8
(22) Date of filing: 01.11.1989
(51) Int. Cl.: H05K 13/04, H05K 3/30, B05C 1/16

(54) **Apparatus for depositing small quantities of fluid**
Apparat zum Aufbringen von geringen Flüssigkeitsmengen
Appareil pour l'application de faibles quantités de liquide

(30) Priority: 18.11.1988 US 273523
(43) Date of publication of application: 06.06.1990
(73) Proprietor: International Business Machines Corporation, Armonk, N.Y. 10504 (US)
(72) Inventor: Habich, Adolph Broaddus, Georgetown Texas 78626 (US); Hermann, Karl, Austin Texas 78758 (US); Hunt, Ronald Eugene, Georgetown Texas 78628 (US); Whitehead, Verlon Eugene, Austin Texas 78759 (US)
(74) Representative: Burt, Roger James, Dr.

(56) References cited:
- EP-A- 0 049 451
- DE-A- 2 935 082

## Description

This invention relates to apparatus for depositing small quantities of fluid in preselected positions on a surface and has a particular application in the automatic placement of electronic components on circuit boards.

DE-A-2 935 082 discloses an apparatus for depositing small quantities of fluid according to the preamble of claim 1.

Due to many factors including the high cost of labour associated with populating electronic circuit boards with circuit components, technology in the electronic manufacturing arts has developed to place such components on boards automatically. The component placement art has developed to a point where a board may be populated with hundreds of circuit components in a matter of seconds and such components may be simultaneously interconnected electrically in a desired fashion by well-known wave solder techniques or the like, as in the case of the emerging surface mounted component technology.

Whereas the component placement equipment and soldering systems have improved tremendously contributing to a rapid throughput in the overall manufacturing process for electronic circuit boards and the like, it has recently been appreciated that weak links or bottlenecks in the manufacturing chain can effectively reduce or eliminate the net gains achieved by improvements in other areas of the process such as the aforementioned advances in soldering and component placement techniques.

One such area recently recognized as having a great impact on the overall process is in the application of adhesives on the electronic circuit boards for purposes of affixing the components thereto during the component placement operation. This technology has become particularly important with the emergence of surface mounted components lacking any intrinsic means of holding themselves in place in contrast with conventional through-hole components held in place by built-in lead preforming, clinching, swaging, or the like.

In a typical application of such surface mount technology, wherein the surface mounted components are wave soldered to the lower surface of a board, the components are held by adhesive to the surface of the board during the soldering operation. In some applications, such as a reflow soldering process, the surface mounted components are retained in position on the surface of the board until completion of the soldering by means of an adhesive. Due to several factors, such as slight asymmetry or irregularity in the solder lands to which the components are to be soldered, vibration, sliding, or floating, the need became apparent for a means of placing accurate and reliable dot patterns of adhesive on the planar surfaces of the boards during the manufacturing process. Moreover, it further became evident that, if such a process step were not to become a bottleneck in the overall electronic circuit board manufacturing process, it would be necessary to provide a system to place such dots of adhesive not only reliably but extremely rapidly so as to keep pace with the emerging simultaneous component placement and soldering techniques.

Accordingly, the conventional known means for adhesive transfer, namely various forms of apparatus having pressure syringes for depositing adhesive dots rapidly became woefully inadequate. Drawbacks of such apparatus included large system size and mechanical complexity rendering the system difficult to clean and maintain but, more importantly, limitation to relatively few on the number of dots which might be placed simultaneously.

Such drawbacks gave rise to refinement of an old art, namely screen printing, for this new application. Whereas such a system incorporating screen printing principles was relatively simple and provided for ease of cleaning and maintenance as well as simultaneous dot placement and uniform dot size, numerous disadvantages were nevertheless present. The most serious of these was the requirement that the planar surface presented to the screen printing process be substantially flat with no obstructions. However, this was impractical due to the requirements of modern electronic circuit board design which typically included boards already pre-populated with other components often of varying heights prior to commencement of the surface mounting process, as, for example, in the case of pre-population with pin and hole components by a different process or other components such as trim potentiometers, variable capacitors, or the like having different vertical dimensions from standardized SMT components or the like. Related to this problem was the conventional practice of populating both sides of a circuit board rendering it difficult to support the unpopulated flat surface of one side of the board so that it could be presented to the screening process when the opposing side was pre-populated with the aforementioned components of varying heights.

Such difficulties and disadvantages with the screen printing technique gave rise to yet a third method of adhesive application known as the pin transfer process. In such a process a pin plate or pin array is fabricated for each printed circuit board or substrate to be processed. Pins are positioned in a plane on the plate in locations corresponding to the desired locations of adhesive dots on the work piece. During the process, the thus-fabricated pin plate is initially positioned so that the pin ends lightly contact a controlled thin layer of adhesive, whereupon drops of the adhesive adhere to the pin ends. The pin plate and board are then urged toward one another in any manner of mechanisms to effect momentary contact of the plurality of pins with the planar surface of the board. Upon withdrawing the pin board, dots of adhesive are thereby deposited on the planar surface of the board in the desired pattern corresponding to the predetermined spatial relationship of the pins on the pin board and, of course, the desired spatial positioning of the surface mounted components to be affixed to the board.

Such a pin transfer process had numerous advantages. The process was relatively simple with little maintenance and provided ease of control of the adhesive quantity and the like. However, there were nevertheless numerous serious disadvantages presented by such a process. First, notwithstanding advances in automated tooling and fabricating machines such as CAD-CAM equipment, fabrication of the pin plates was nevertheless costly and time consuming. It will be appreciated that a new pin plate would be required for every variation of component makeup and positioning associated with different circuit board products. Thus, for example, each design modification could require the machining or etching of an entire new pin plate or set of such plates to provide pins in the desired pattern. Secondly, whereas the aforementioned pressure syringe process could be adapted in some cases to accommodate non-flat circuit boards, the pin transfer process suffered the same drawback as the screen printing techniques, namely that they were primarily adapted for accommodating flat surfaces. One reason for this was that the pins, being fashioned of a metal, are substantially non-compliant and thus, for example, could not accommodate curved or irregular surfaces such as those typically presented by slightly warped circuit boards common in the art, or larger boards, by means of increasing the pressure with which the pins and the circuit boards were brought into contact. Such inability to accommodate irregular surfaces resulted in non-uniform dot placement and, in the worst of cases, failure to place some dots of adhesive at all. A further drawback of known pin transfer processes was based on the inclusion of manual steps required in the process which accordingly did not lend itself to rapid, modern production line techniques.

Due to the large numbers of extremely small components capable of being rapidly and simultaneously placed on circuit boards and electrically connected thereto, it is readily apparent that an adhesive transfer process which provided for extremely accurate and simultaneous adhesive pattern placement was highly desired. Moreover, such a process which readily accommodated easy and economical changes in the desired spatial positioning of the adhesive pattern to accommodate different products was highly desired. Moreover, such a process which further could accommodate wide variations in the characteristics of the surface presented for adhesive deposition in terms of irregularities including those associated with warpage, large boards, and boards pre-populated with other components, as well as the problems well known in the art associated with pre-population of boards on the opposing side to that which was to receive the adhesive transfer was desired.

The object of the present invention is to provide improved apparatus for use in depositing small quantities of fluid in selected positions on a surface.

The present invention relates to apparatus for depositing small quantities of a fluid in selected positions on a surface comprising a holder supporting a plurality of pins arranged in accordance with the selected positions, means for placing a small quantity of fluid on the end of each pin, means for moving each pin into contact with the surface in a corresponding one of the selected positions so as to deposit the fluid on the pin in the corresponding position, and compliance means in each pin adapted to allow movement of the pin relative to the holder to compensate for any unevenness in the surface.

According to the invention the apparatus is characterised in that the compliance means is retained in position in the holder by means of a plurality of latch fingers.

According to another aspect, the present invention is characterised in that the means for placing a small quantity of fluid on the end of each pin comprises a reservoir of fluid, and means for inserting the end of each pin into the reservoir, the reservoir preferably comprising a layer of fluid on the surface of a plate, and a spreader knife for spreading the thin film of fluid on the surface of the plate.

According to yet another aspect, the present invention is characterised in that the apparatus further comprises means for straightening out the surface in order to compensate for unevenness in said surface.

In order that the invention may be more readily understood, an embodiment will now be described with reference to the accompanying drawings, in which:
Fig. 1 is a side view, partly in section, of the apparatus for use in applying dots of adhesive to an electronic circuit board depicted in a first operational state,
Fig. 2 is a side view, partly in section, of the apparatus illustrated in Fig. 1 depicted in a second operational state,
Fig. 3 is an exploded perspective view, partly in section, of an adhesive plate module included in the apparatus illustrated in Figs. 1 and 2,
Fig. 4 is an exploded view of a portion of the module illustrated in Fig. 3,
Fig. 5 is a side view, partly in section, of the adhesive collection and spreading components of a plate module depicted in Fig. 1 in a first operational state in which adhesive or glue is being collected,
Fig. 6 is a side view, partly in section, of the components of the adhesive plate module illustrated in Fig. 5 in a second operation state in which adhesive is being transferred,
Fig. 7 is a side view, partly in section, of the components of the adhesive plate module illustrated in Fig. 5 in a third operational state in which the adhesive is being applied,
Fig. 8 is a side view, partly in section, of the components of the adhesive plate module illustrated in Fig. 5 in a fourth operational state in which the adhesive is being spread evenly over the surface of the adhesive plate,
Fig. 9A is a perspective view of a pin component carried by a pin plate of the apparatus illustrated in Fig. 1,
Fig. 9B depicts a side view, partly in section, of the pin plate and a circuit board, showing a representative pin component when installed in the pin plate,
Fig. 9C depicts a side view in cross section of an alternative form of pin component,
Fig. 10 is a side view, partly in section, of a conveyor/lifter module of the apparatus illustrated in Figs. 1 and 2 in a first operational state prior to contact between the pin components and the adhesive plate,
Fig. 11 is a side view, partly in section, of the conveyor/lifter module illustrated in Fig. 10 in a second operational state during contact between the pin components and the adhesive plate,
Fig. 12 is a side view, partly in section, of the conveyor/plate lifter module illustrated in Fig. 10 during contact of the pin components with a circuit board 8,
Figs. 13A and 13B are top and bottom views, respectively, of the pin plate showing a plurality of pin components installed therein,
Fig. 13C and 13D are top and bottom views, respectively, of a representative circuit board 8 illustrating correspondence between the pattern of pin components shown in Figs. 13A and 13B and the pattern formed by circuit components to be placed on the circuit board,
Fig. 14 is a side view, partly in section, of the components of the adhesive plate module illustrated in Fig. 5 in an operational state similar to that depicted in Fig. 8, and
Fig. 15 is an exploded perspective view of a portion of the conveyor/lifter module of the apparatus illustrated in Fig. 1.

First an overall general description will be provided of the structure and operation of apparatus for applying dots of adhesive to a circuit board prior to a more detailed description of the structure and operation of the various components of the apparatus.

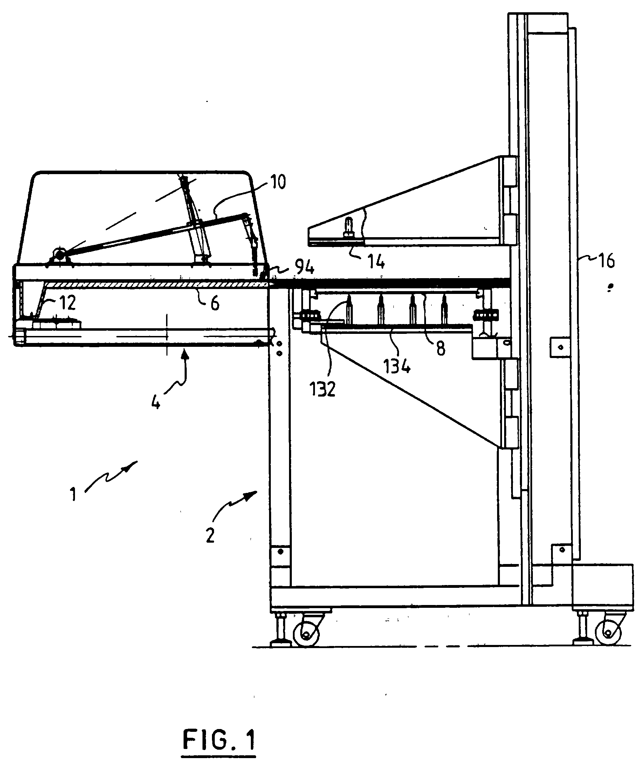

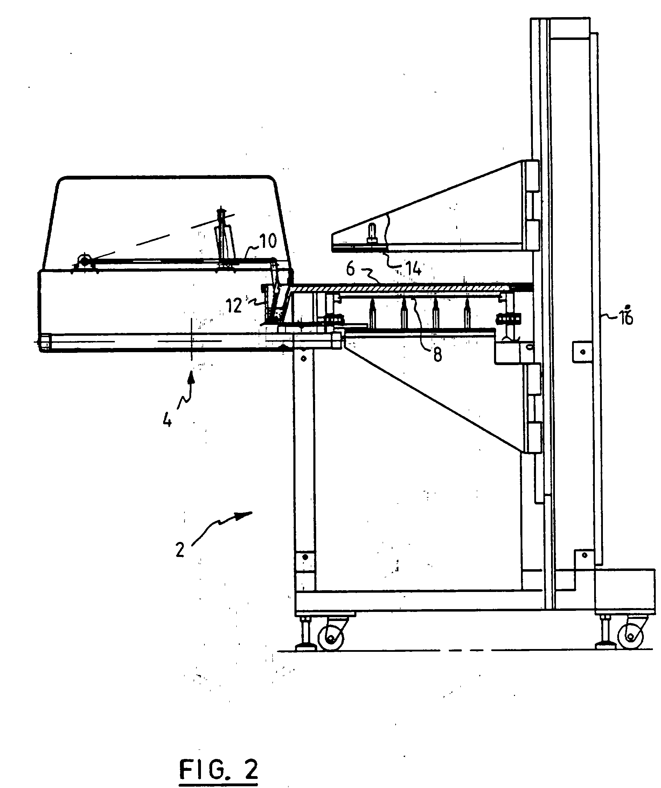

Referring first to Figs. 1 and 2, there is shown an apparatus 1 for gang placement of a pattern of dots of adhesive in selected positions on the surface of a printed circuit board. The apparatus includes a conveyor/lifter module 2 and an adhesive plate module 4. The adhesive plate 6 of module 4 is periodically moved into and out of vertical registration with cooperating components in module 2, travelling in directions generally perpendicular to that of a conveyor which carries a circuit board 8 laterally into and out of module 2 prior to and after deposition of the adhesive dots onto the surface of board 8.

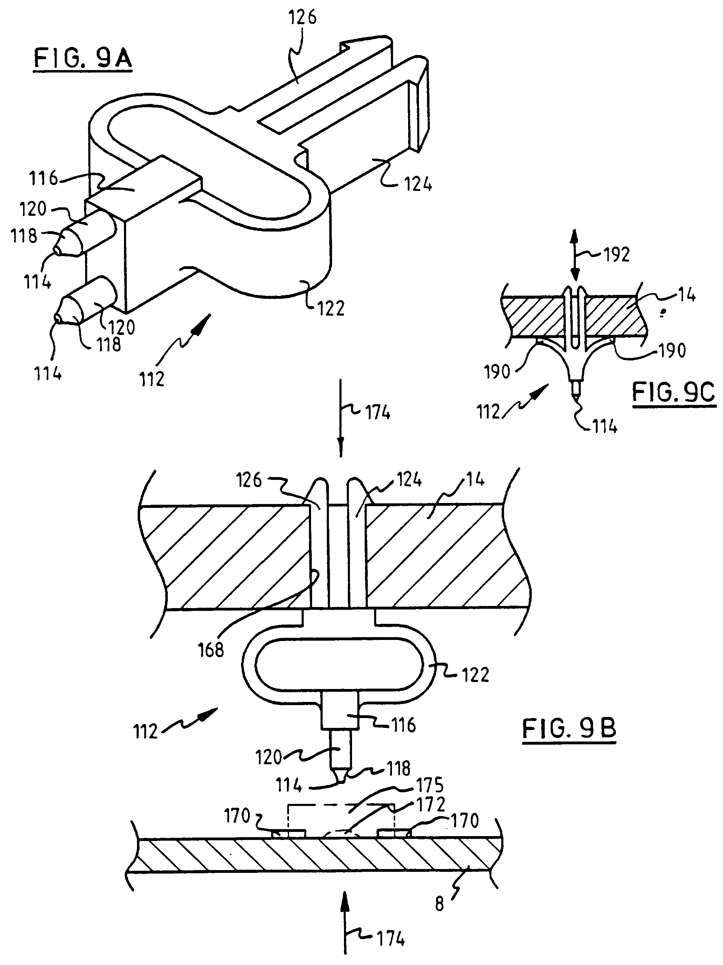

A pin plate 14 has a plurality of adhesive dot pin components (Fig. 9A) projecting downwardly therefrom in a predetermined pattern. The pattern corresponds to the pattern of adhesive dots desired to be deposited on the circuit board 8, each dot of which is intended to retain a corresponding circuit component on the board 8 temporarily prior to a soldering operation during which the component is secured in position permanently. Fig. 1 shows the plate 6 retracted back into the adhesive plate module 4 where the upper surface of the plate 6 will be periodically coated with a layer of adhesive in a manner to be described. Fig. 2 shows the plate 6 moved into module 2 where portions of a layer of adhesive on the upper surface of the plate 6 are removed by the lowermost portions of the pins carried by plate 14 and transferred to corresponding positions on the upper surface of circuit board 8.

With reference and more detail to the latter step of adhesive being removed from the upper surface of glue plate 6 by the pins and then deposited on the upper surface of the board 8, adhesive plate module 4 comprises a pivoting adhesive lifter and application assembly 10, the adhesive plate 6 which includes a pot 12 containing adhesive, and an adhesive knife member 94 for spreading a thin film of adhesive on the surface of the plate 6. Conveyor/lifter module 2 holds the pin plate 14 in a position for removing portions of the adhesive from the plate 6. A modular frame assembly 16 is further provided for positioning the pin plate 4 and the circuit board 8 together in contact periodically to transfer adhesive dots from the lower ends of pins in the pin plate 14 to the upper surface of the circuit board 8.

In summary, the frame assembly 16 carries a conveyor mechanism (to be described in more detail hereinafter) whereby the printed circuit board 8 requiring adhesive dot deposition and subsequent component placement will be introduced to the conveyor assembly and drawn into vertical registration with the pin plate 14 (which, it will be recalled, will carry the plurality of downwardly projecting adhesive dot pin components illustrated in Fig. 9A). A mechanism associated with the adhesive plate module 4, also to be hereinafter described and including adhesive lifter and application assembly 10 and adhesive pot 12, will cause a thin layer of adhesive from the pot 12 to be applied to the upper surface of the adhesive plate 6. The plate 6 is then moved to the right (with reference to Fig. 1) until the plate 6 is disposed in vertical registration between the pin plate 14 and the circuit board 8. The lower protruding ends of the pins on the pin components in the pin plate 14 are then caused to move into contact with the adhesive on the upper surface of the plate 6, also by means of a mechanism to be hereinafter described. The lower portions of the pins on the pin plate 14 will pick up dots of adhesive from contact with the adhesive on the surface of the plate 6. The adhesive plate 6 is then automatically moved in the leftward direction from the position shown in Fig. 2 back into the adhesive plate module 4, as shown in Fig. 1. The apparatus 1 will then be in a condition whereby the various pins on the pin plate 14 are positioned in vertical registration over the locations on the upper surface of the circuit board 8 whereon dots of adhesive are to be placed.

Next, the pin plate 14 and circuit board 8 are moved together in the vertical direction so as to effect contact between the lower portions of the pins carried on the plate 14 and the upper surface of the circuit board 8, thereby causing the pins to deposit the dots of adhesive carried on the lower portions of the pins onto the upper surface of the circuit board 8 in the desired pattern. The pin plate 14 and circuit board 8 are then-moved apart in the vertical direction, whereupon the conveyor mechanism causes the board 8 which has just had adhesive dots deposited thereon in the desired pattern to be ejected from the apparatus 1. The operation may then be repeated for the next circuit board on which adhesive dots are to be placed. This next circuit board will be positioned on the conveyor mechanism on the opposite side of the frame assembly from that side which just ejected the board 8. Upon further operation of the conveyor mechanism, this next circuit board is in like manner brought into vertical registration with the pin plate 14 whereupon the process repeats in depositing adhesive dots in the desired pattern on the next such board.

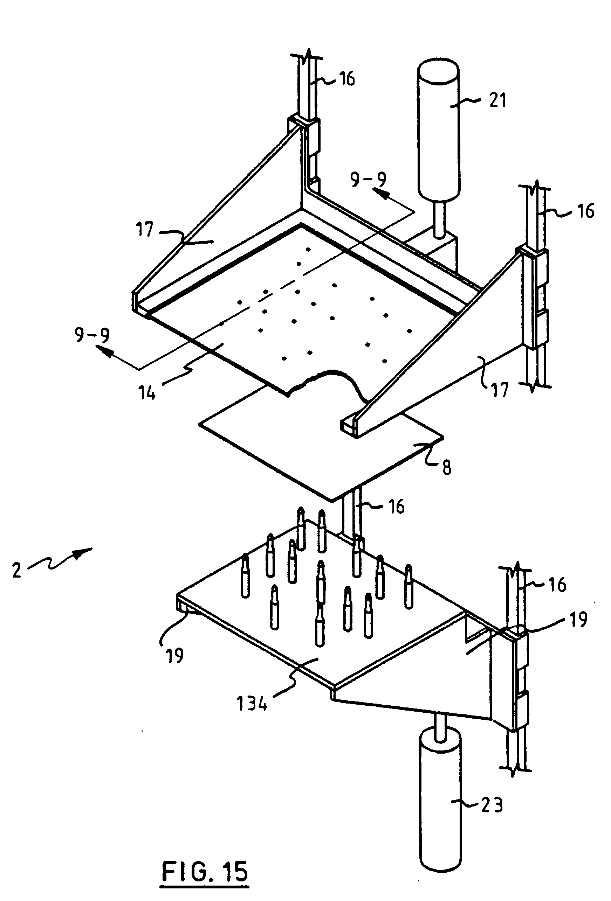

Referring to Fig. 15 briefly, apparatus for effecting the relative movement of pin plate 14 and a lower lift plate 134 towards and away from the circuit board 8 may be seen. The pin plate 14 is supported by upper brackets 17 which slide vertically on the frame assembly member 16. Interconnected between these brackets 17 and the frame assembly 16 is a pneumatic cylinder 21. Upon energization of this cylinder 21, the brackets 17 may be urged upwards and downwards in the direction of the longitudinal axis of the frame assembly 16, thereby translating the pin plate 14 supported by the brackets 17 in the desired vertical direction. In like manner, brackets 19 which support the lower plate 134 ride also on the frame assembly 16. A pneumatic cylinder 23 when activated urges the lower plate 134 in the desired vertical direction.

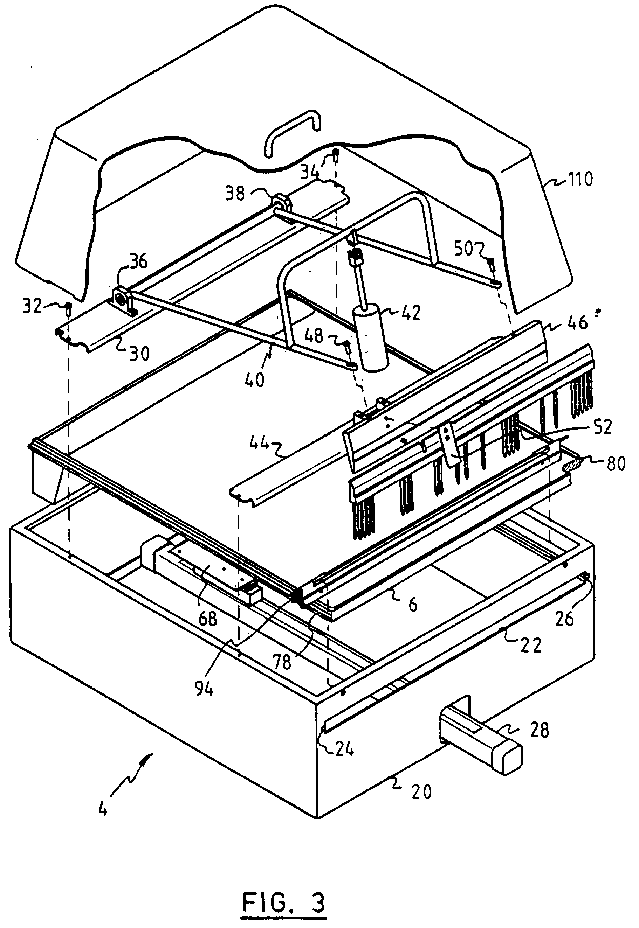

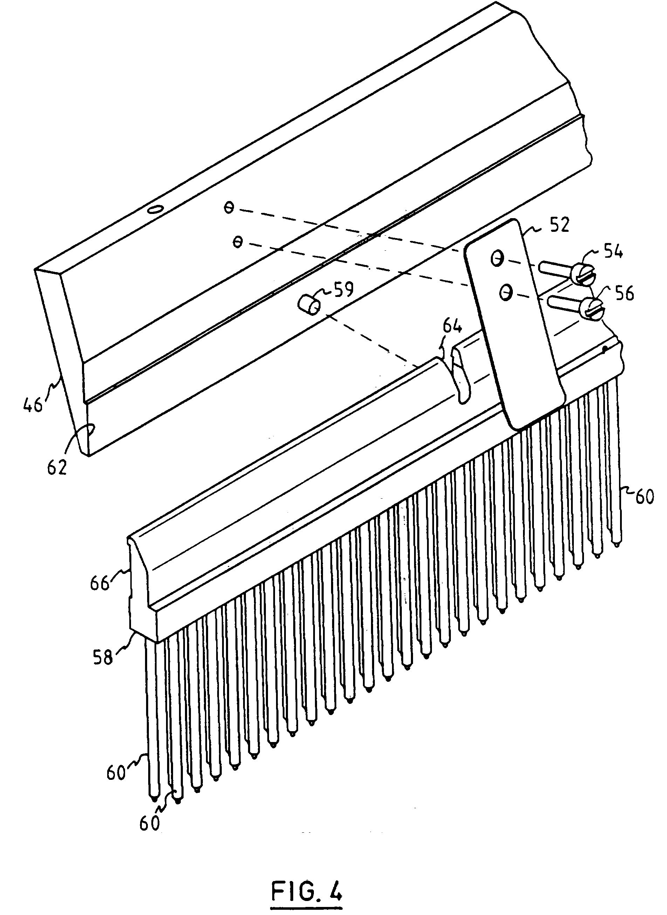

Referring now to Fig. 3, adhesive plate module 4 consists of a frame member 20 containing a slot opening 22, drawer slide grooves 24 and 26, and an air cylinder 28. Cross member 30, attached to frame member 20 by screws 32 and 34, holds bearing blocks 36 and 38. A wireform lifter arm 40 rotates in blocks 36 and 38 and is raised and lowered by an air cylinder 42 which is attached to a cross member 44. A mounting block 46 is attached to a lifter arm 40 by screws 48 and 50. Fig. 4 more clearly shows a leaf spring 52 fastened to mounting block 46 by screws 54 and 56. An adhesive finger assembly 58, comprising a plurality of fingers 60, is for lifting and distributing adhesive in a manner which will be hereinafter described. Adhesive finger assembly 58 snaps on and off mounting block 46 for ease of cleaning. A pin 59 in a raised surface 62 on block 46 cooperates with a slot 64 and a groove 66 in assembly 58 to locate the parts together and the spring 52 provides a holding force as required.

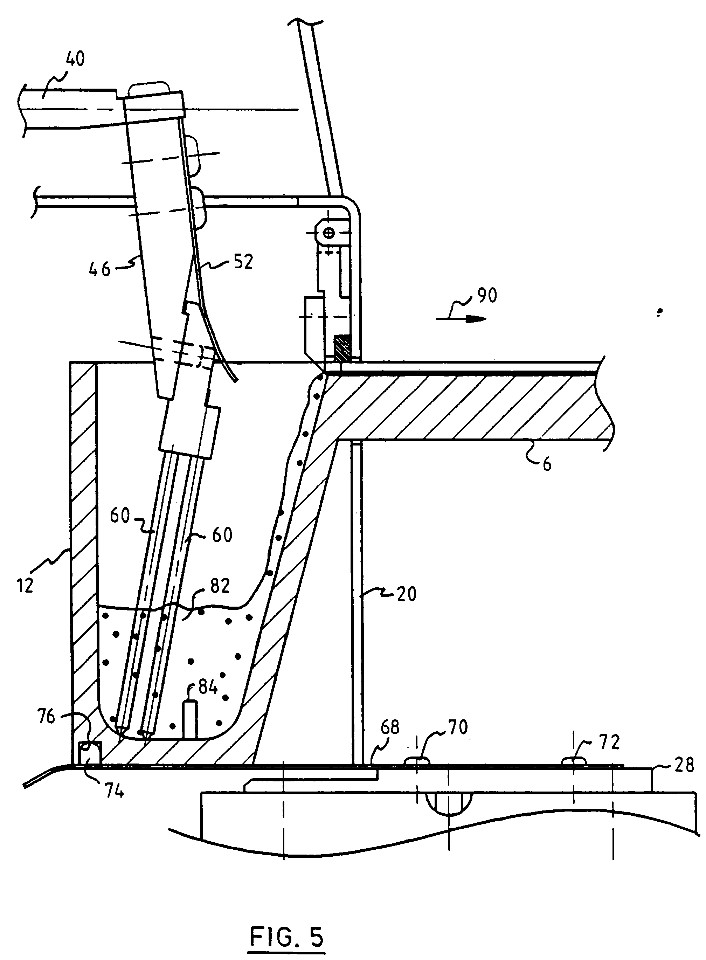

Referring now to Figs. 3 and 5, a substantially flat adhesive plate 6 and attached adhesive pot 12 are removable attached for ease of cleaning to a conventional rodless air cylinder 28. A leaf spring 68 is mounted on air cylinder 28 by screws 70 and 72. A locking pin 74 is attached to spring 68 and mates with a hole 76 in the bottom of pot 12 to attach the plate 6 to the air cylinder 28. Rails 78 and 80, on the edge of plate 6, slide in drawer slide grooves 24 and 26 in frame member 20, when driven by air cylinder 28.

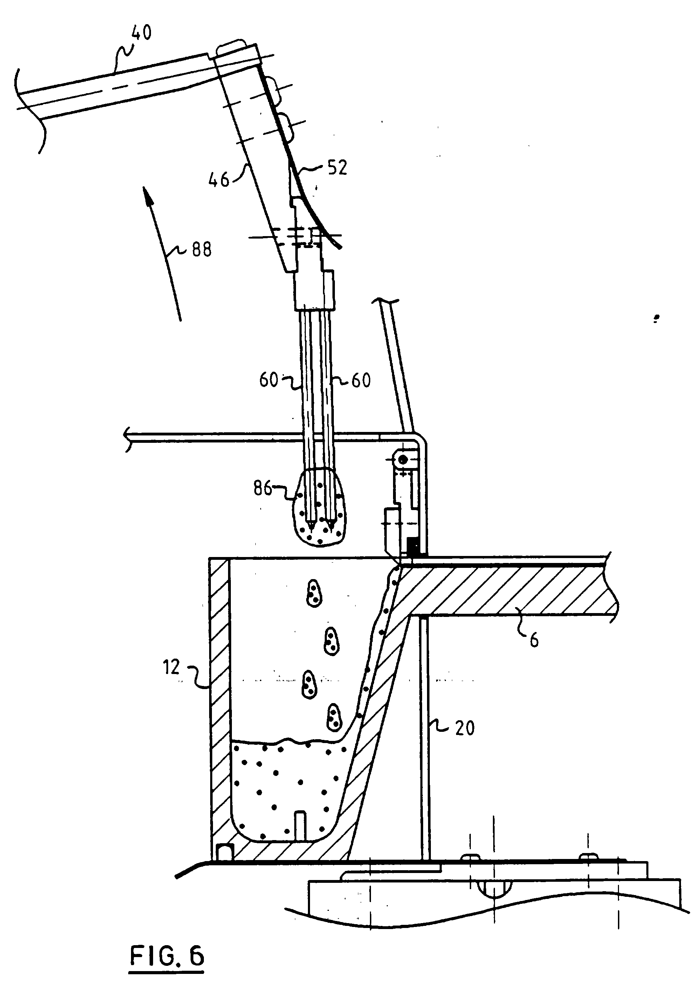

Referring now to Figs. 5 - 8, the method of an application of adhesive to the movable flat plate 6 will be described. In Fig. 5, plate 6 is shown positioned fully to the right within conveyor/lifter module 2 (Fig. 2) having been moved in the direction of arrow 90 by air cylinder 28, with the fingers 60 having been lowered by air cylinder 42 (Fig. 3) into a mass of adhesive 82 in pot 12. Pin 84 in the bottom of pot 12 is used as a visual adhesive low level indicator. In Fig. 6, arm 40 is shown rotated in the direction of arrow 88 by air cylinder 42, thereby raising fingers 60 above plate 6. A residual mass of adhesive 86 is retained on the fingers 60.

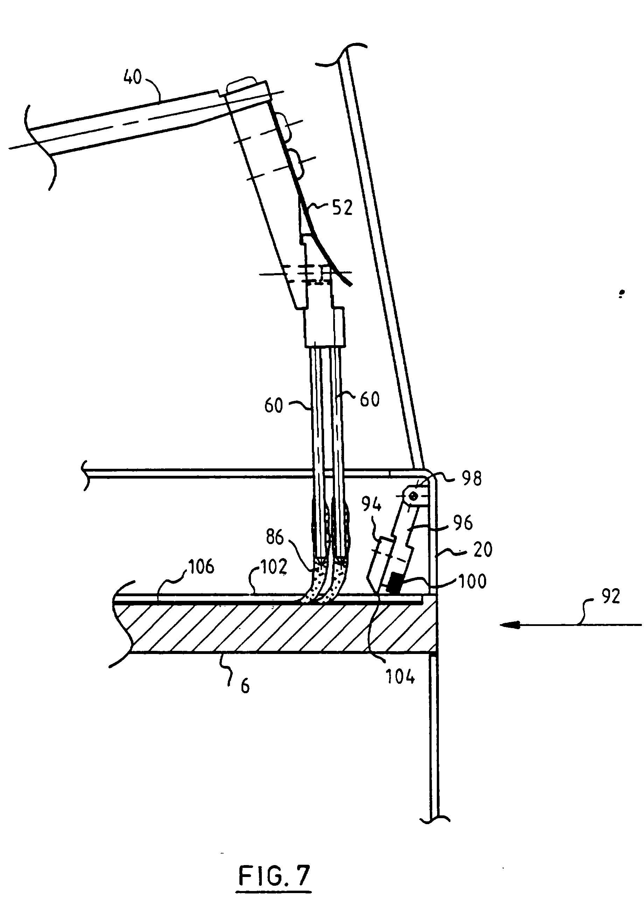

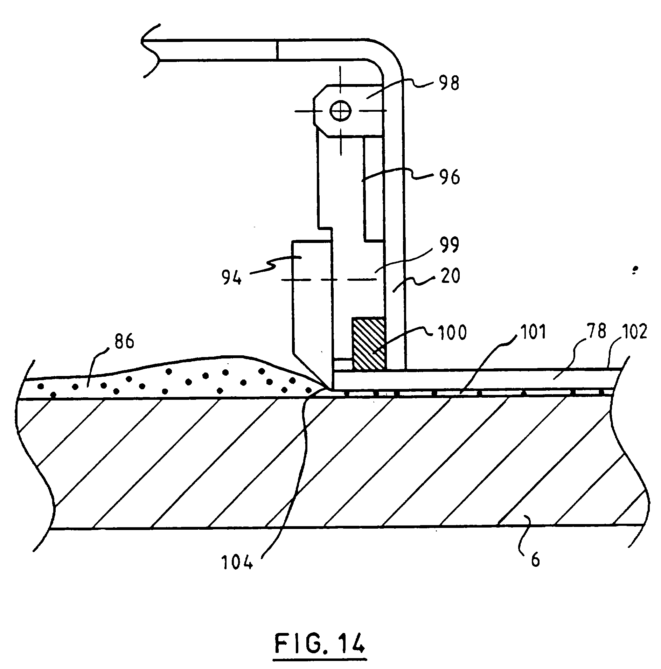

Now with reference to Fig. 7, plate 6 has been moved back into module 4, as illustrated in Fig. 1 and as indicated by arrow 92, from the position shown in Figs. 2, 5 and 6. An adhesive spreader knife 94 is attached to a pivotable arm 96 which pivots freely in bearing blocks 98 on opposing sides of frame member 20. An elastomer block 100 attached to pivotable arm 96 slidingly engages the edges 102 of plate 6 (see Fig. 14). When plate 6 is moved in the direction of arrow 92, the friction force of block 100 dragging on edges 102 rotates pivotable arm 96 and a spreader edge 104 on knife 94 clockwise, thereby lifting the edge 104 above the upper surface 106 of plate 6. During such movement, adhesive 86 drips from fingers 60 onto the upper surface 106 of plate 6.

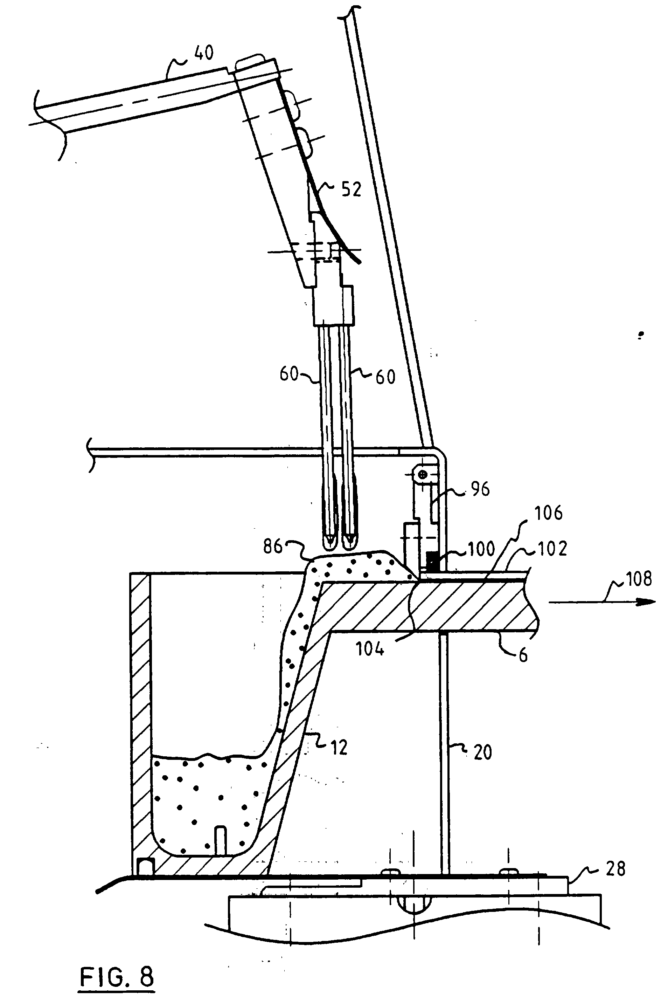

Now referring to Fig. 8, plate 6 is shown being moved in the direction of arrow 108, as occurs when moving from the position of Fig. 1 to that of Fig. 2. During such movement the elastomer block 100, rubbing on the upper surface 102 of plate 6, rotates the pivotable arm 96 counterclockwise until block 100 contacts frame 20. When this occurs, there is a small clearance between adhesive spreader edge 104 on the knife 94 and the upper surface 106 of plate 6. This clearance controls the thickness of the layer of adhesive spread on the surface 106 when plate 6 is moved in the direction of arrow 108 by air cylinder 28. The excess adhesive 86 is pushed back into pot 12 with a "squeegee"-type action to be reused in the next cycle of the apparatus 1.

In Fig. 14 the function of the elastomer block 100 may be seen more clearly depicted. When the plate 6 is moving to the right, the adhesive spreader knife 94 is rotated counterclockwise with elastomer block 100 being compressed so as to ride on the rail 78. A stop 99 on the arm 96 abutting against the frame member 20 prevents further counterclockwise rotation of the arm and the spreader knife and maintains the spreader knife 94 in the substantially vertical position shown in Fig. 14. In this manner a uniform layer or film 101 of adhesive 86 is spread on the upper surface 106 of the glue plate 6.

Referring back to Fig. 3, a transparent top cover 110 for plate module 4 provides operator protection from moving parts as well as environmental protection from possible adhesive fumes while allowing the cycle of operation of the apparatus to be observed.

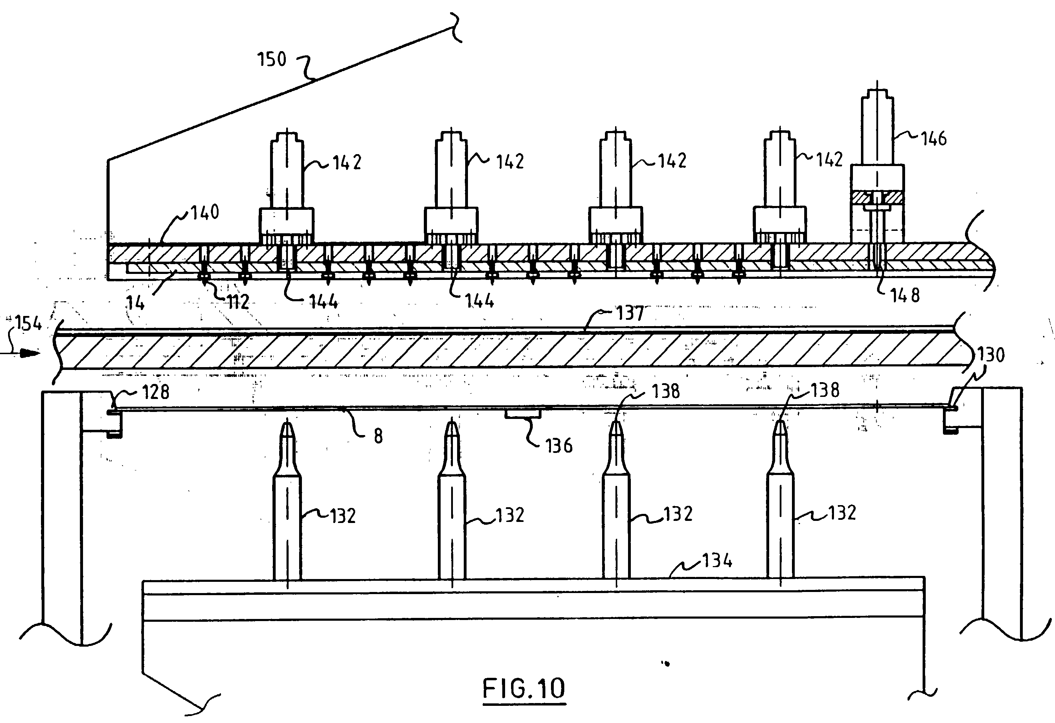

Now that the description has been provided of how a thin film of adhesive is spread on the flat upper surface 106 of plate 6, it will be hereinafter explained how portions of this adhesive film are removed and transferred to selected positions on a printed circuit board 8. A more detailed description of moulded adhesive-transfer pin components 112 will now be given with reference to Figs. 9 and 10. These pin components extend downwards from pin plate 14 in a pattern corresponding to the pattern of dots desired to be placed on the circuit board 8. It will be noted from Fig. 9A that in each pin component 112 two cylindrical rods 120 with tapered end parts 118 and end surfaces 114 project from a main body 116. The end parts 118 and surfaces 114 form pins which enable drops of adhesive to be picked up from the thin film of adhesive (deposited as just described on the upper surface 106 of plate 6) and the release of each drop to a selected position on the upper surface of board 8. Adjacent to body 116 is a moulded compliant elongated O-shaped spring member 122 which, by a spring-like action, limits the force exerted by the end surfaces 114 on the circuit board 8 and also provides a tolerance for small variations in heights of the pin components or for the board 8 surface irregularities (caused by warpage of the board or the like). Spring member 122 is attached to two latch fingers 124 and 126 which latch in slots in the flat pin plate 14 (see Fig. 10) and provide a compact arrangement for attaching the pin component 112 to the plate 14.

Fig. 9B is a side view, sectioned along line 9-9 of Fig. 15, of the pin plate 14. The section passes through one of the pin components 112 when installed on and thus carried by the pin plate 14. A plurality of apertures 168 are disposed through the pin plate 14 in a pattern corresponding to the desired positions of adhesive dots on the surface of the circuit board 8. Also seen in Fig. 9B is a side view of a part of the circuit board 8 indicating lands 170 on the upper surface thereof for electrical interconnection with a circuit component such as the surface mounted component 175 shown in dashed lines. A dot of adhesive 172 (illustrated by dashes) will be formed on the upper surface of the board 8, being deposited from the end surface 114 of a pin component 112 upon its contact with the upper surface of board 8. Upon subsequent placement of the surface mounted circuit component 175 on the adhesive dot 172 by means of a suitable component placement machine (not illustrated), the component 175 will be caused to adhere to the board 8 for subsequent electrical interconnection between the leads thereof and the lands 170.

As the board 8 and pin plate 14 are urged toward one another as indicated by arrows 174, the adhesive on the end surface 114 will be caused to contact the upper surface of the board 8. Fig. 9B illustrates the function of the spring member 122 of the pin component 112 in providing for compliant movement of the end surface 114 relative to the pin plate 14 thereby compensating for variations in distance between a particular end surface 114 and corresponding opposing location on the circuit board 8. Thus, as individual end surfaces 114 or the adhesive thereon engage the surface of board 8, additional relative movement shown by arrows 174 may continue without damage to the board surface or adverse affects on deposition of the adhesive until adhesive dots carried by all the pin components 112 have engaged the board 8 surface.

Fig. 10 is a side view of the circuit board portion of conveyor/lifter module 2 depicted in Fig. 1 sectioned along line 9-9 of Fig. 15. Pin plate 14 holds a plurality of adhesive transfer pins 112 in a product-determined pattern which corresponds to selection positions on circuit board 8. Board 8 is supported and transported by continuous conveyor belts 128 and 130 which are driven by a motor means not shown. Circuit board 8 can be lifted from belts 128 and 130 by a plurality of support pins 132 attached to lower lift plate 134. The pins 132 are positioned so as to avoid vertical registry with any components 136 already assembled on the underneath surface of the board 8, and ends 138 of support pins 132 thereby provide a flat plane of support for the board 8. Plate 134 is moved up and down in a conventional manner by air cylinder 23 (see Fig. 15).

Adhesive plate 6 with a thin film of adhesive 137 is shown as in Fig. 2 positioned between board 8 and pin plate 14. Plate 14 is rigidly fastened to upper lift plate 140. Attached to lift plate 140 are a plurality of conventional air cylinders 142 that are positioned in vertical registration over corresponding pins 132. The shaft end 144 of each cylinder 142 will be employed as described later to flatten the board 8 against the pin ends 138. An air cylinder 146 fixed to plate 140 has a tapered aligning pin 148 which will be used also in a manner to be described to align board 8 with pin plate 14.

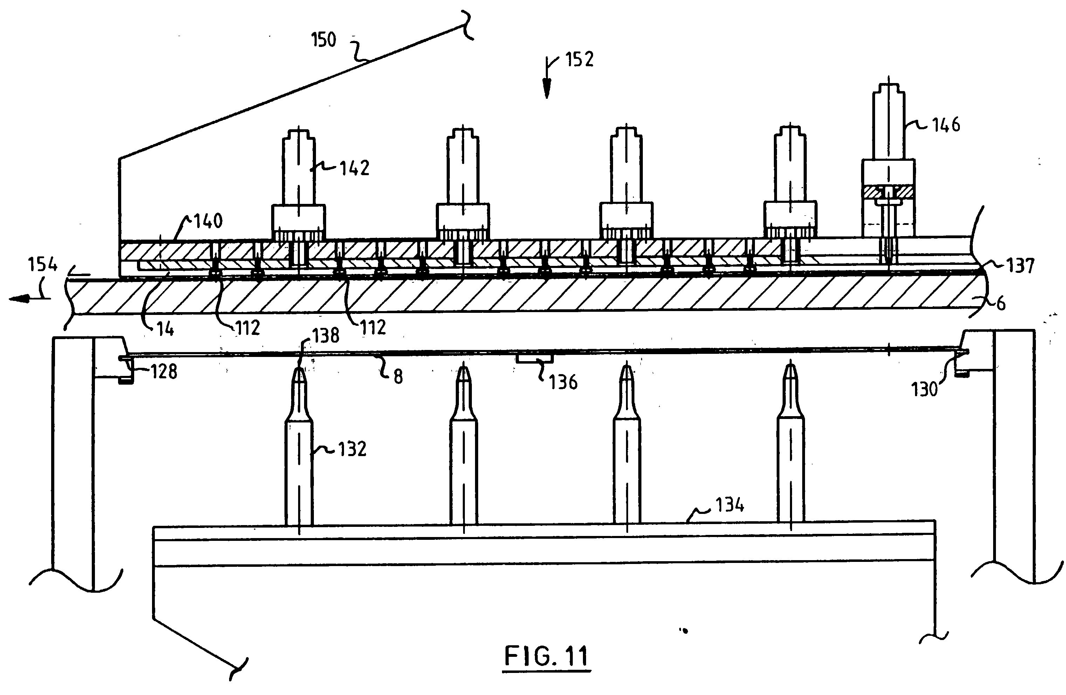

Referring now to Fig. 11, upper lift plate assembly 150 is lowered in the direction of arrow 152 until the ends 114 (see Fig. 9A) of the pin components 112 rest on the thin adhesive film 137 on plate 6. Pressure is applied downward on upper lift plate assembly 150 forcing the partial collapse of spring members 122 (see Fig. 9A) of pin components 112 assuring contact of all pins to adhesive film 137 on plate 6. Plate assembly 150 is then raised and plate 6 is moved to the left as shown by arrow 154. Adhesive has now been transferred from the plate 6 to the ends of pins 112.

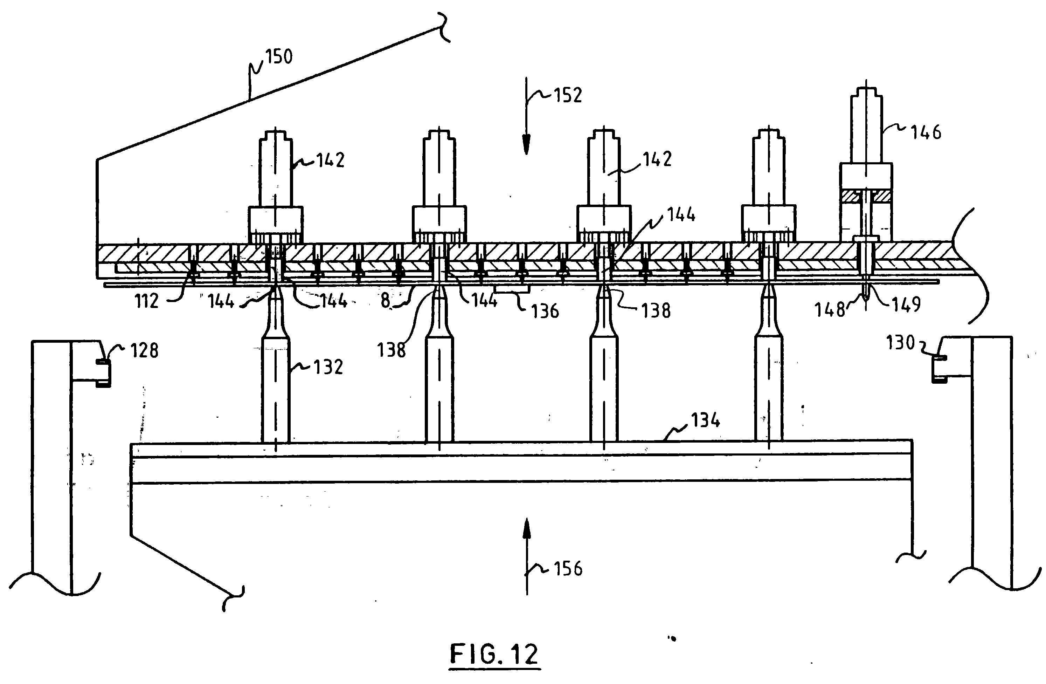

Fig. 12 depicts backup plate 134 lifting the board 8 off conveyor belts 128 and 130 in the direction of arrow 156 and upper plate assembly 150 being lowered in the direction of arrow 152 with the board 8 being sandwiched therebetween. Aligning pin 148 on air cylinder 146 is extended into a mating hole 149 in board 8, thereby locating board 8 in a preselected horizontal position before ends 114 on pin components 112 come to rest on preselected positions on board 8 and the adhesive on the ends 114 is deposited in the preselected positions on the board 8. Air cylinders 142 are then energized so as to urge plunger ends 144 to flatten board 8 against support pin ends 138, with the ends 144 and 138 being in vertical registration. Upper plate assembly 150 is then raised, and lower plate 134 is lowered thereby leaving board 8 with adhesive drops in the preselected positions and the board 8 resting on conveyor belts 128 and 130. Board 8 is then conveyed out of the assembly 1 by means of the belts 128 and 130 and a new board brought into the assembly by such means and the cycle is thereby completed.

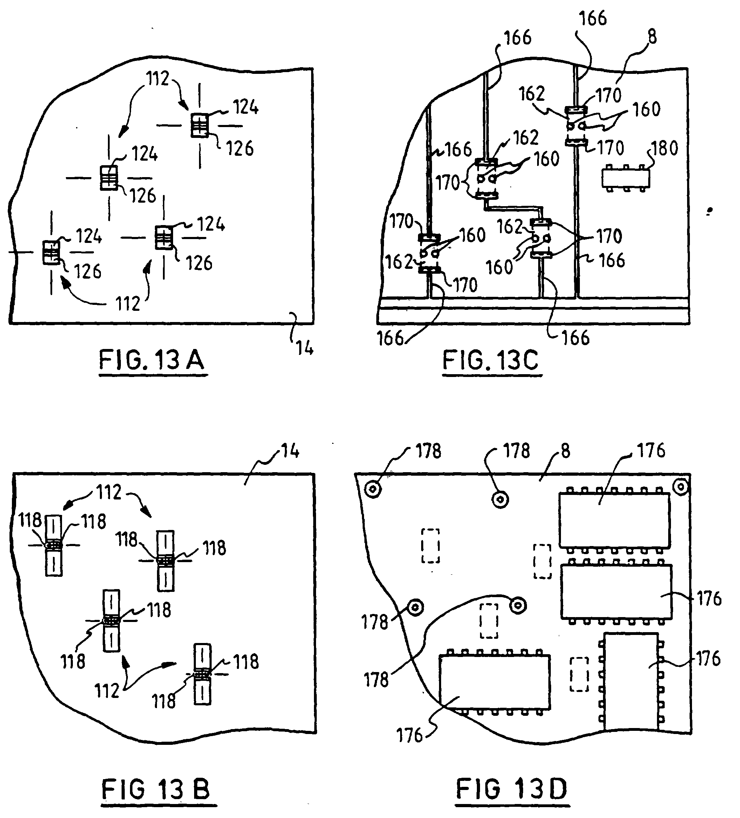

In Fig. 13A is illustrated a pin plate 14 having a plurality of the hereinbefore described pin components 112 installed therein in corresponding spatial relation to the spatial relation defined by surface mounted components 162 to be placed on the circuit board 8 as shown in Fig. 13C. As illustrated in Fig. 13A which is a top view of the pin plate 14, a plurality of pin components 112 depicted in greater detail in Fig. 9B are carried by the plate 14 with the uppermost portions of the latch fingers 124 and 126 of each respective pin component 112 being visible. Fig. 13B is a bottom view of the pin plate 14 of Fig. 13A indicating the pattern of tapered end parts 118 of corresponding pin components 112 carried by the board 14. In accordance with the adhesive depositing operation hereinbefore described, the end surfaces 114 shown in Fig. 13B of the pin components 112 will eventually become loaded with adhesive dots for subsequent deposition on the upper surface of the circuit board 8.

With reference to Fig. 13C, the upper surface of board 8 is shown depicted therein after the end surfaces 114 of the pin components 112 carried by the pin plate 14 have been moved onto the upper surface of the circuit board 8 so as to deposit adhesive dots 160 in the desired pattern on the upper surface of the circuit board 8. The resultant pattern of adhesive dots 160 deposited on the surface of board 8 is simply a function of the predetermined spatial positioning of the pin components 112 in the pin plate 14 and the corresponding spatial positioning of the end surfaces 114 of pin components 112. Still referring to Fig. 13C surface mounted circuit components 162 are shown therein by dotted lines indicating the function of the adhesive dots 160 in causing the components 162 to adhere to the board 8 adjacent their respective lands 170 shown in Fig. 9B. Electrically conductive paths 166 are interconnected to these lands 170 in desired patterns and, once the circuit components 162 have been placed on their respective adhesive dots 160, such interconnection between the components 162 may be completed as provided by these paths 166 by any number of means known well in the art in effecting electrical interconnection between the paths and corresponding lands 170 such as by wave soldering or the like.

In Fig. 13D, a bottom view is shown of a representative but highly simplified circuit board 8 having circuit components 176 already pre-populating the board 8 prior to deposition of adhesive dots on the board 8. The purpose of Fig. 13D is to indicate schematically that the support pins 132 (Fig. 10) should be positioned on the lower lift plate 134 so as to contact the lower surface of board 8 at locations 178 away from the components 176 in order to provide a uniform support formed by the uppermost ends of the support pins 132 against the lower surface of board 8 thereby avoiding irregularities formed by the pre-mounted components 176. This feature contributes significantly to the ability of the pin components 112 to effect uniform placement of a plurality of adhesive dots on the upper surface of the board 8 by providing a uniform underneath support for the board 8 throughout its planar surface. This is particularly beneficial when it is necessary to counteract the additional forces required to bring all of the end surfaces 114 of the pin components 112 into proper contact with the upper surface of board 8 during conditions wherein the distances between all end surfaces 114 and corresponding opposing locations on the upper surface of board 8 differ (as, for example, in the case of a warped board or the like).

Fig. 13C also illustrates that in some instances the upper surface of board 8 may also be pre-populated by circuit components such as that represented at reference numeral 180 prior to effecting the adhesive deposit as described above. In like manner to the just-described case in which support pins 132 should be positioned on lift plate 134 to accommodate the circuit components 176, it will be appreciated that the pin components 112 should in like manner be positioned as desired in the pin plate 114 so as to avoid contact of the end surfaces 114 with such previously installed circuit components 180.

Before describing some details of a particular embodiment, an overall summary of the steps of operation of the apparatus would be helpful. With the apparatus shown in the operating state of Fig. 2, it will be recalled that the fingers 60 are deposited downwards onto the pot 12 of adhesive and the plate 6 is moved rightwards into the conveyor/lifter module 2. Upon energization of the air cylinder 42 (Fig. 3) the fingers 60 are moved upwards to the position shown in Fig. 6. Upon energi'zation of the air cylinder 28, the plate 6 is thereby moved outwards of the conveyor/lifter module 2 and leftwards from the operating position shown in Fig. 2 to that of Fig. 1. During such movement of the plate 6 leftwards and underneath the fingers 60, the adhesive mass 86 on the fingers (Fig. 6) is caused to drip onto the upper surface of the plate 6. During such movement leftwards, the adhesive spreader knife 94 is rotated clockwise slightly off the vertical as shown in Fig. 7. A circuit board 8 is then inserted into the side of the conveyor/lifter module 2 and conveyed by means of the belts 128 and 130 into position between the pin plate 14 and lower lift plate 134. Upon re-energization of the air cylinder 28, the plate 6 is moved rightwards from the position and operating state shown in Fig. 1 to that of Fig. 2. During such movement, it will be recalled the spreader knife 94 is moved into the vertical position illustrated in Fig. 8 with the adhesive spreader edge 104 contacting the upper surface 102 of the surface 106 of plate 6 thereby spreading out the somewhat irregularly previously deposited adhesive drippings into a uniform layer on the top surface of the plate 6.

When the rightward travel of the plate 6 is completed as shown in Fig. 2, the air cylinder 21 of Fig. 15 is activated moving the plate assembly 150 downwards from the position of Fig. 11 to that of Fig. 10 whereby the end surfaces 114 of the pin components 112 contact the uniform adhesive film 137 on the upper surface of plate 6 so as to receive dots of adhesive thereupon. The air cylinder 21 is then reactivated to lift the plate assembly 150 back to the position shown in Fig. 10. The air cylinder 28 is next reactivated causing leftward movement again of the plate 6 outwards of the conveyor/lifter module 2. When the plate 6 is first moved to the right depositing the adhesive at the end of its travel, the fingers 60 will fall back into the pot 12 replenishing the supply of adhesive 86 on the fingers 60 in preparation for the next cycle.

Adhesive dots have been transferred to the pins 112. Air cylinder 23 of Fig. 15 is then activated moving the lower lift plate 134 and support pins 132 carried thereby in an upwards direction into engagement with the lower surface of the circuit board 8. Similarly, air cylinders 142 of Fig. 12 are also activated urging the upper lift plate in a downwards direction. Air cylinder 146 is then activated to bring aligning pin 148 into mating engagement with a hole 149 in board 8 thereby locating the board 8 before the adhesive on the ends of end surfaces 114 contacts the upper surface of the board 8. Air cylinders 142 are then further energized so as to urge end surfaces 114 closer towards the circuit board 8 thereby depositing the adhesive dots in the desired pattern on the upper surface of board 8. It will be recalled that the sandwiching effect provided by the force of the air cylinders 142 urging the pin plate 14 downwards and the support provided by the support pins 132 will flatten board 8 against the support pins 132 to provide a more uniform planar surface for receipt of the adhesive dots from the end surfaces 114. Downward motion of assembly 150 compresses spring members 122 of pins 112 allowing compliance of pins to the board 8. The upper plate assembly 150 is then raised and the lower lift plate 134 lowered in response to appropriate energization of air cylinders 21 and 23, respectively, leaving the board 8 with the adhesive dots in the selected position. The board 8 is then conveyed out on belts 128 and 130 and a new board brought in for the next adhesive transfer cycle.

It will be appreciated that, whereas a particular embodiment has been disclosed relating to the deposit of adhesive dots for use in mounting components or double sided circuit boards, the apparatus described can be modified to incorporate a wide range of embodiments, applications, and variations requiring various adjustments and adaptations in a manner known to those skilled in the art. For example, the apparatus described is not intended to be limited to deposit of adhesives only but could be modified for the deposit of other fluid materials as desired such as solder paste or the like in any desired pattern. In like manner, the apparatus need not be limited to applications only wherein it is desired to affix surface mounted components to a planar surface of a circuit board but may be modified for uses wherein patterns of some fluid are simply desired to be deposited on a planar surface whether or not used in conjunction with subsequent placement of articles thereon. It should be evident that adjustments in the timing of operation of various steps, clearances and tolerances and the like are also easily modified to meet the requirements of a particular application. For example, it may be desirable to adjust the clearance of the adhesive spreader knife 94 to vary the adhesive layer thickness as desired. In a similar manner, it may be desirable to vary the amount of deflection vertically caused by the contact of the end surfaces 114 adjacent the upper surface of the board 8 by means of any number of adjustments including the composition of material of the pin components 112, thickness of the spring member 122, etc.

It will be appreciated that the pin components 112 described could be modified to provide numerous alternative arrangements and are not intended to be limited to the form shown in Fig. 9A. For example, in the Fig. 9A arrangement two cylindrical rods 120 and corresponding end surfaces 114 are shown. However, it is contemplated that in some applications it may be desirable to provide for only one such adhesive dot forming extension from the pin component 112 or, in other applications, it may be desirable to provide more than the two which are shown. In like manner, the important feature of the pin component 112 in providing compliance along the longitudinal direction is provided by means of the spring member 122 including the hollowed out portion. However, the apparatus could be modified to provide alternative designs providing equivalent function. As but one example, the spring member 122 may in the alternative be provided by an intermediate portion of the pin component 112 taken up by the spring member 122 being fashioned of a solid resilient material such as rubber or the like. Alternatively, as shown in Fig. 9C, the pin component 112 may include two or more fingers 190 or a disk-shaped radially outward extending portion of sufficiently thin wall thickness so as to provide the desired compliance or flexibility in the direction of arrows 192 when the pin tip 114 contacts the printed circuit board 8.

In a conventional application wherein it is desired to affix surface mount circuit components on a planar surface of a circuit board, the following table indicates parameters that appear to provide consistent successful results in the placement of such components:

**Table**

| | |
|---|---|
| Adhesive | Amicon D-124F Uniset |
| Pin component compliance , compression | .008-.011 |
| Pin component composition | Delrin (Acetal) |
| | |
| Adhesive layer depth | Adjustable .020" - .040", nominally .038" |
| Temperature range | 68°F-78°F (20°C-25.5°C) |
| Length of time pin in | 1-20 sec. |
| Adhesive layer | nominally 1-3 secs. |

## Claims

1. Apparatus for depositing small quantities of a fluid in selected positions on a surface (8) comprising:
a holder (14) supporting a plurality of pins (112) arranged in accordance with said selected positions,
means (4,6,137) for placing a small quantity of fluid on the end (114) of each pin,
means (16,17,21) for moving each pin into contact with said surface (8) in a corresponding one of said selected positions so as to deposit the fluid on said pin in said corresponding position, and
compliance means (122;190) in each pin adapted to allow movement of said pin relative to said holder (14) to compensate for any unevenness in said surface,
characterised in that:
said compliance means is retained in position in said holder by means of a plurality of latch fingers (124,126).

2. Apparatus as claimed in claim 1 wherein the compliance means comprises a deformable substantially O-shaped ring (122).

3. Apparatus as claimed in claim 1 wherein the compliance means comprises a deformable disc (190).

4. Apparatus as claimed in any of the preceding claims wherein the means for placing a small quantity of fluid on the end of each pin comprises:
a reservoir of fluid (117), and
means (16,17,21) for inserting the end of each pin into said reservoir.

5. Apparatus as claimed in claim 4 wherein the reservoir comprises:
a layer of fluid (137) on the surface of a plate (6), and a spreader knife (94) for spreading said thin film of fluid on the surface of the plate.

6. Apparatus as claimed in any one of the preceding claims further comprising means for straightening out said surface (8) in order to compensate for unevenness in said surface.

7. Apparatus as claimed in claim 6 wherein the means for straightening comprises:
a back up plate (132,134,138) for supporting the surface (8) remote from the surface on which the fluid is to be deposited,
a set of movable rods (142,144), and
means for forcing said rods against the surface on which the fluid is to be deposited in order to force the board against said back up plate.

8. Apparatus as claimed in any one of the preceding claims wherein:
said fluid is an adhesive and said surface is the surface of a printed circuit board, and
circuit components to be electrically connected into the printed circuit on said board can be attached to said surface by means of said small quantities of adhesive deposited on said surface.

## Patentansprüche

1. Ein Apparat zum Aufbringen geringer Flüssigkeitsmengen auf ausgewählte Positionen auf einer Oberfläche (8) mit:
einer Haltevorrichtung (14), die zahlreiche Stifte (112) hält, welche in Übereinstimmung mit den ausgewählten Positionen angeordnet sind,
einem Mittel (4, 6, 137) zum Auftragen einer geringen Flüssigkeitsmenge auf das Ende (114) jedes Stifts,
einem Mittel (16, 17, 21) zum Bewegen jedes Stifts, so daß dieser an einer entsprechenden der ausgewählten Positionen in Kontakt mit der Oberfläche (8) kommt, um die Flüssigkeit auf dem Stift auf der entsprechenden Position aufzubringen, und
einem Nachgiebigkeitsmittel (122, 190) in jedem Stift, das die Bewegung des Stift relativ zur Haltevorrichtung (14) ermöglicht, um Unebenheiten auf der Oberfläche auszugleichen,
und der Apparat dadurch gekennzeichnet ist, daß:
das Nachgiebigkeitsmittel von zahlreichen Haltefingern (124, 126) in seiner Position in der Haltevorrichtung gehalten wird.

2. Ein Apparat nach Anspruch 1, bei dem das Nachgiebigkeitsmittel einen verformbaren, im wesentlichen O-förmigen Ring (122) umfaßt.

3. Ein Apparat nach Anspruch 1, bei dem das Nachgiebigkeitsmittel eine verformbare Scheibe (190) umfaßt.

4. Ein Apparat nach einem der oben genannten Ansprüche, bei dem das Mittel zum Auftragen einer geringen Flüssigkeitsmenge auf dem Ende jedes Stifts folgendes umfaßt:
einen Flüssigkeitsbehälter (117) und
ein Mittel (16, 17, 21) zum Eintauchen des Endes jedes Stifts in den Behälter.

5. Ein Apparat nach Anspruch 4, bei dem der Behälter folgendes umfaßt:
eine Flüssigkeitsschicht (137) auf der Oberfläche einer Platte (6) und ein Streichmesser (94) zum Verteilen des dünnen Flüssigkeitsfilms auf der Oberfläche der Platte.

6. Ein Apparat nach einem der oben genannten Ansprüche, der weiterhin über ein Mittel zum Richten der Oberfläche (8) verfügt, um Unebenheiten auf der Oberfläche auszugleichen.

7. Ein Apparat nach Anspruch 6, bei dem das Richtmittel folgendes umfaßt:
eine Stützplatte (132, 134, 138) zum Stützen der Oberfläche (8) fern von der Oberfläche, auf der die Flüssigkeit aufgebracht werden soll,
eine Reihe drehbarer Stangen (142, 144) und
ein Mittel zum Drücken der Stangen gegen die Oberfläche, auf der die Flüssigkeit aufgebracht werden soll, um die Platine gegen die Stützplatte zu drücken.

8. Ein Apparat nach einem der oben genannten Ansprüche, bei dem:
die Flüssigkeit ein Klebstoff ist, und die Oberfläche die Oberfläche einer gedruckten Schaltung ist, und
Schaltkomponenten, die auf der gedruckten Schaltung elektrisch miteinander verbunden werden, mit Hilfe der geringen, auf der Oberfläche aufgebrachten Klebstoffmengen an der Oberfläche angebracht werden können.

## Revendications

1. Appareil pour l'application de faibles quantités de liquide dans des positions sélectionnées sur une surface (8), comprenant :
un support (14) supportant une pluralité de tiges (112) agencées selon lesdites positions sélectionnées,
des moyens (4, 6, 137) pour placer une faible quantité de liquide sur l'extrémité (114) de chaque tige,
des moyens (16, 17, 21) pour déplacer chaque tige afin de la mettre en contact avec ladite surface (8) dans l'une correspondante desdites positions sélectionnées de façon à appliquer le liquide se trouvant sur ladite tige à ladite position correspondante, et
des moyens élastiques (122; 190), prévus dans chaque tige et adaptés pour permettre un déplacement de chaque tige par rapport audit support (14), afin de compenser toute inégalité de ladite surface,
caractérisé en ce que :
lesdits moyens élastiques sont maintenus en position dans ledit support à l'aide d'une pluralité de doigts de verrouillage (124, 126).

2. Appareil selon la revendication 1, dans lequel les moyens élastiques comprennent un anneau déformable (122) sensiblement en forme de O.

3. Appareil selon la revendication 1, dans lequel les moyens élastiques comprennent un disque déformable (190).

4. Appareil selon l'une quelconque des revendications précédentes, dans lequel le moyen d'application d'une petite quantité de fluide sur l'extrémité de chaque tige comprend :
un réservoir de fluide (117), et
des moyens (16, 17, 21) pour insérer l'extrémité de chaque tige dans ledit réservoir.

5. Appareil selon la revendication 4, dans lequel le réservoir comprend :
une couche de fluide (137) sur la surface d'une plaque (6) et une lame d'étalement (94), destinée à étaler ledit film mince sur la surface de la plaque.

6. Appareil selon l'une quelconque des revendications précédentes, comprenant en outre des moyens pour redresser ladite surface (8), afin de compenser les inégalités de ladite surface.

7. Appareil selon la revendication 6, dans lequel les moyens de redressement comprennent :
une plaque de pressage (132, 134, 138) destinée à supporter la surface (8) à distance de la surface sur laquelle le fluide doit être déposé,
un jeu de tiges mobiles (142, 144), et
des moyens pour pousser lesdites tiges contre la surface sur laquelle le fluide doit être appliqué, de manière à forcer la plaquette à venir contre ladite plaque de pressage.

8. Appareil selon l'une quelconque des revendications précédentes, dans lequel :
ledit fluide est un adhésif et ladite surface est la surface d'une plaquette de circuit imprimé, et
des composants de circuit, devant être reliés électriquement dans le circuit imprimé sur ladite plaquette, peuvent être fixés à ladite surface, au moyen desdites petites quantités d'adhésif appliquées sur ladite surface.
